# EUROPÄISCHE PATENTSCHRIFT

(11) **EP 3 058 614 B1**
(45) Veröffentlichungstag und Bekanntmachung des Hinweises auf die Patenterteilung: **11.07.2018**
(21) Anmeldenummer: 14793770.0
(22) Anmeldetag: 14.10.2014
(51) Int. Cl.: H01M 10/42, H01L 51/05, H01M 10/44, H02J 7/00

(54) **SCHALTVORRICHTUNG FÜR EINEN ELEKTROCHEMISCHEN ENERGIESPEICHER UND ENERGIESPEICHERSYSTEM**
SWITCHING DEVICE FOR AN ELECTROCHEMICAL ENERGY STORAGE AND ENERGY STORAGE SYSTEM
DISPOSITIF DE COMMUTATION POUR ACCUMULATEUR D'ÉNERGIE ÉLECTROCHIMIQUE ET SYSTÈME D'ACCUMULATION D'ÉNERGIE

(30) Priorität: 17.10.2013 DE 102013017228
(43) Veröffentlichungstag der Anmeldung: 24.08.2016
(73) Patentinhaber: Airbus Defence and Space GmbH, 85521 Ottobrunn (DE)
(72) Erfinder: KAISER, Alexander, 78669 Wellingen (DE); OHNESORGE, Alexander, 85649 Brunnthal (DE); HOFMANN, Michael, 85579 Neubiberg (DE); STEINWANDEL, Jürgen, 88690 Uhldingen (DE); PILAWA, Michael, 80807 München (DE)
(74) Vertreter: LKGLOBAL Lorenz & Kopf PartG mbB Patentanwälte
(86) Internationale Anmeldenummer: PCT/DE2014/000505
(87) Internationale Veröffentlichungsnummer: WO 2015/055164

(56) Entgegenhaltungen:
- EP-A1- 2 081 275
- WO-A1-00/16429
- WO-A2-00/07276
- GB-A- 2 465 122

## Beschreibung

### Technisches Gebiet

Die Erfindung betrifft eine Schaltvorrichtung für einen elektrochemischen Energiespeicher, einen elektrochemischen Energiespeicher und ein Energiespeichersystem.

### Technischer Hintergrund

Die DE 1 952 984 9 A1 beschreibt elektrochemische Zellen mit einer Schutzvorrichtung, die mindestens zwei parallel geschaltete Elektroden gleicher Polarität besitzen und die als Energiespeicher mit hoher Energiedichte, wie sie in Elektrostraßenfahrzeugen verwendet werden, eingesetzt werden.

Die elektrochemischen Zellen werden bei der dort beschriebenen Schutzvorrichtung vor dem Bersten bzw. dem Totalausfall ganzer Zellen geschützt und eine Schädigung der Zellen wird fallweise angezeigt, wobei mindestens zwei parallel geschaltete Elektroden gleicher Polarität vorhanden sind, wobei jede der parallel geschalteten Einzelelektroden gleicher Polarität mit einem Sicherungselement verbunden sind.

Das dort beschriebene Sicherungselement unterbricht den elektrischen Kontakt zwischen den Einzelelektroden und dem die Einzelelektroden verbindenden Stromableiter, wenn ein Stromschwellwert überschritten wird, wobei sie eine Nachweiseinrichtung besitzen, die das Ansprechen eines Sicherungselementes außerhalb der Zelle anzeigt.

Die EP 2 081 275 A1 offenbart eine Schaltvorrichtung für einen elektrochemischen Energiespeicher, mit einer Transistoreinrichtung.

Die DE 29 17 328 C3 beschreibt ein galvanisches Element mit einer Schmelzsicherung.

### Beschreibung

Es ist eine Aufgabe der Erfindung, eine Sicherheitsfunktion für einen elektrischen Energiespeicher bereitzustellen.

Diese Aufgabe wird durch die Gegenstände der unabhängigen Patentansprüche gelöst. Weiterbildungen der Erfindung ergeben sich aus den Unteransprüchen und der folgenden Beschreibung.

Gemäß einem Aspekt der Erfindung ist eine Schaltvorrichtung für einen elektrochemischen Energiespeicher vorgesehen, die Schaltvorrichtung umfasst eine Folientransistoreinrichtung, welche mindestens einen organischen Transistor aufweist und welche innerhalb eines Schichtsystems mindestens einer Elektrode des elektrochemischen Energiespeichers flächig angebracht ist und welche von einer externen Spannungsquelle steuerbar ist und als ein steuerbarer elektrischer Widerstand in Reihe zu einem Innenwiderstand des elektrochemischen Energiespeichers ausgebildet ist.

Es ist eine Idee der Erfindung, für elektrochemische Energiespeicher, d.h. für Batterien oder Akkumulatoren, ein An- und/oder Abschalten des Stromflusses zu ermöglich, um im Fehlerfall, etwa bedingt durch einen systeminternen oder externen Kurzschluss, den Stromfluss durch die Zelle bzw. den elektrochemischen Energiespeicher unterbrechen zu können.

Die der Erfindung zugrunde liegende Idee liegt darin, einen oder mehrere organische Transistoren in Form einer durch eine externe Spannungsquelle schaltbaren Folie auf einer oder beiden Elektroden im Batterie-Verbundsystem zu integrieren, so dass der zum restlichen Innenwiderstand der Zelle in Reihe liegende Widerstand des organischen Transistors über eine extern angelegte Spannung gezielt geschaltet werden kann, d.h. die Zelle wird niederohmig oder hochohmig geschaltet. Auch ein definierter Leitwert, etwa zum gezielten Erzeugen von Verlustwärme ist realisierbar. Der Schalter ist so in den Elektronenleitpfad einzubinden, dass keine nachteiligen Wechselwirkungen mit anderen Komponenten der Batteriezelle stattfinden.

Gemäß einem weiteren Aspekt der Erfindung ist vorgesehen, dass die Folientransistoreinrichtung dazu ausgebildet ist, in einer Zelle des elektrochemischen Energiespeichers angeordnet zu werden. Dies erlaubt einen kompakten Aufbau des elektrochemischen Energiespeichers mit einer integrierten Schaltervorrichtung.

Gemäß einer weiteren vorteilhaften Ausführungsform der Erfindung ist vorgesehen, dass die Schaltvorrichtung ferner eine Regelungseinrichtung aufweist, welche dazu ausgebildet ist, den aktuell vorherrschenden Innenwiderstand des elektrochemischen Energiespeichers zu erfassen und basierend auf dem erfassten Innenwiderstand einen Gesamtwiderstand des Innenwiderstands und des in Reihe zugeschalteten steuerbaren elektrischen Widerstands einzustellen. Dies erlaubt auf einfache Weise, ohne Wechselwirkung mit der galvanischen Zelle, den Innenwiderstand anzupassen.

Gemäß einer weiteren vorteilhaften Ausführungsform der Erfindung ist vorgesehen, dass die Folientransistoreinrichtung räumlich getrennt von einem Aktivmaterial der Elektrode ist. Dies erlaubt vorteilhaft, eine chemische Reaktion zwischen Aktivmaterial und der Folientransistoreinrichtung zu verhindern.

Gemäß einer weiteren vorteilhaften Ausführungsform der Erfindung ist vorgesehen, dass der organische Transistor zwischen mindestens zwei Metallfolien angeordnet ist. Dadurch kann der organische Transistor vorteilhaft direkt kontaktiert werden.

Gemäß einer weiteren vorteilhaften Ausführungsform der Erfindung ist vorgesehen, dass der mindestens eine organische Transistor der Folientransistoreinrichtung als ein organischer Feldeffekt-Transistor ausgebildet ist. Dies erlaubt einen einfachen und kompakten Aufbau der Folientransistoreinrichtung.

Gemäß einer weiteren vorteilhaften Ausführungsform der Erfindung ist vorgesehen, dass der organische Feldeffekt-Transistor in vertikaler Anordnung ausgebildet ist.

Gemäß einer weiteren vorteilhaften Ausführungsform der Erfindung ist vorgesehen, dass der organische Feldeffekt-Transistor in horizontaler Anordnung ausgebildet ist.

Gemäß einer weiteren vorteilhaften Ausführungsform der Erfindung ist vorgesehen, dass der organische Feldeffekt-Transistor Quellen- und Senkenbereiche aufweist, welche jeweils eine Mehrzahl von ineinandergreifenden Kontaktfingern aufweisen. Dadurch können sichere und leistungsfähige Strompfade zur Kontaktierung der organischen Schicht bereitgestellt werden.

Gemäß einer weiteren vorteilhaften Ausführungsform der Erfindung ist vorgesehen, dass die Folientransistoreinrichtung dazu ausgebildet ist, auf der mindestens einen Elektrode des elektrochemischen Energiespeichers mit Hilfe von einem Druckverfahren angebracht zu werden. Dies erlaubt vorteilhaft, die Folientransistoreinrichtung auf einfache Weise und kostengünstig herzustellen.

Gemäß einer weiteren vorteilhaften Ausführungsform der Erfindung ist vorgesehen, dass eine Flächenausdehnung der Folientransistoreinrichtung im Wesentlichen einer Flächenausdehnung der Elektrode entspricht.

Gemäß einer weiteren vorteilhaften Ausführungsform der Erfindung ist vorgesehen, dass die Folientransistoreinrichtung biegsam ausgebildet ist.

Die beschriebenen Ausgestaltungen und Ausführungsformen lassen sich beliebig miteinander kombinieren.

Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

### Kurze Beschreibung der Zeichnungen

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: eine schematische Darstellung einer Schaltvorrichtung für einen elektrochemischen Energiespeicher gemäß einer Ausführungsform der Erfindung;
- Fig. 2: eine schematische Darstellung eines vertikalen organischen Transistors zur Erläuterung der Erfindung;
- Fig. 3: eine schematische Darstellung eines vertikalen organischen Transistors zur Erläuterung der Erfindung;
- Fig. 4: eine schematische Darstellung einer Schaltvorrichtung für einen elektrochemischen Energiespeicher gemäß einer weiteren Ausführungsform der Erfindung;
- Fig. 5: eine schematische Darstellung eines horizontalen organischen Transistors zur Erläuterung der Erfindung;
- Fig. 6: eine schematische Darstellung einer Schaltvorrichtung für einen elektrochemischen Energiespeicher gemäß einer weiteren Ausführungsform der Erfindung; und
- Fig. 7: eine schematische Darstellung eines Energiespeichersystems gemäß einer weiteren Ausführungsform der Erfindung.

In den Figuren der Zeichnung bezeichnen gleiche Bezugszeichen gleiche oder funktionsgleiche Elemente, Bauteile, Komponenten oder Verfahrensschritte, soweit nichts Gegenteiliges angegeben ist.

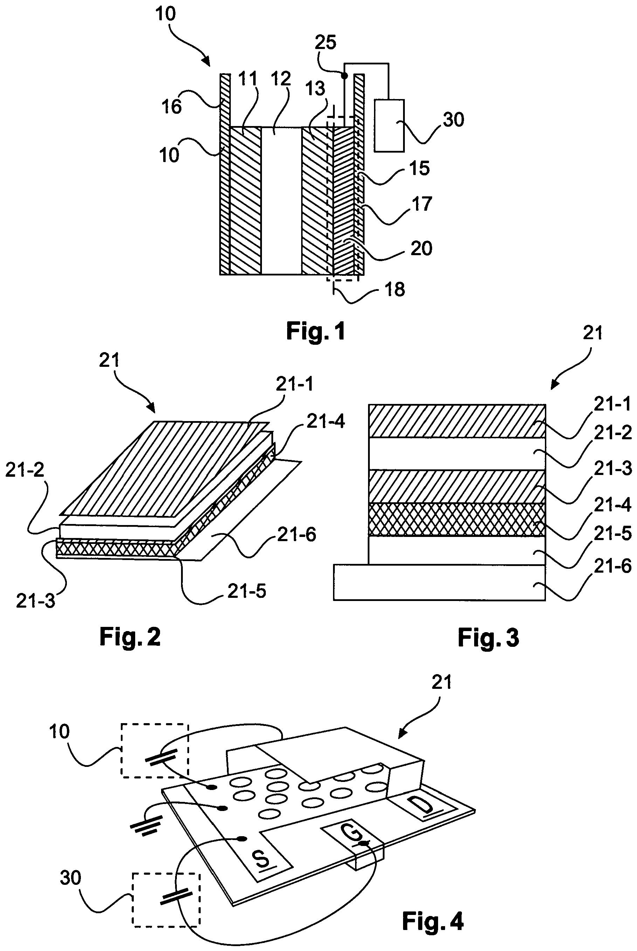

Die Figur 1 zeigt eine schematische Darstellung einer Schaltvorrichtung für einen elektrochemischen Energiespeicher gemäß einer Ausführungsform der Erfindung.

Die Schaltvorrichtung 15 für den elektrochemischen Energiespeicher 10 umfasst eine Folientransistoreinrichtung 20.

Die Folientransistoreinrichtung 20 kann auf der Rückseite eines als Trägerfolie ausgebildeten Stromableiters 16, 17 einer Elektrode des elektrischen Energiespeichers 10 aufgebracht werden. Dabei wird sichergestellt, dass es nicht zu Reaktionen zwischen dem (organischen) Transistormaterial und dem Aktivmaterial 11, 13 der Elektrode, dem Elektrolyten oder anderen Inhaltsstoffen des Energiespeichers 10 kommt.

Eine Trennfläche 18 der Folientransistoreinrichtung 20 kann als eine metallische oder elektrische leitfähige Folie oder Schicht ausgebildet sein und das Aktivmaterial 11, 13 sowie den Elektrolyten von der Folientransistoreinrichtung 20 mechanisch trennen, das heißt einen Stoff- oder Massenfluss durch die Trennfläche 18 verhindern.

Ein Separator 12 des elektrischen Energiespeichers 10 kann als eine Zwischenlage in Form einer ionendurchlässigen Folie ausgebildet sein und mit einem Elektrolyten getränkt werden.

In einer vorteilhaften Ausführung der Erfindung wird hierzu eine weitere Elektronen-leitfähige Folie zwischen organischem Feldeffekttransistor 20 bzw. 21, 22 und Aktivmaterial 11, 13 eingebracht.

Die Folientransistoreinrichtung kann mindestens einen organischen Transistor 21, 22 aufweisen und kann innerhalb des Schichtsystems mindestens einer Elektrode des elektrochemischen Energiespeichers 10 flächig angebracht werden, wobei die Elektrode des Energiespeichers üblicherweise aus einem Verbund von Stromableiter, Aktivmaterial, Binder und ggf. weiteren Konstituenten besteht.

Über einen Verbinder 25 zu einer externen Spannungsquelle 30 kann an den organischen Transistor 21, 22 eine Steuer- oder Gatespannung angelegt werden. Dies erlaubt, den organischen Transistor 21, 22 anzusteuern und in Form eines steuerbaren elektrischen Widerstands einen Innenwiderstand des elektrochemischen Energiespeichers 10 zu steuern.

Dabei ist der organische Transistor 21, 22 beispielsweise mit dem Innenwiderstand des elektrischen Energiespeichers 10 in Reihe geschaltet. Ferner kann ein weiterer organischer Transistor 21, 22 mit dem Innenwiderstand des elektrischen Energiespeichers 10 parallel geschaltet werden, um den elektrischen Energiespeicher 10 überbrücken zu können.

Denkbar ist auch eine Kapselung des organischen Transistors 21, 22 beispielsweise zwischen zwei Lagen Metallfolie. Bei einer direkten Verbindung des organischen Transistors 21, 22 mit einem Aktivmaterial der Zelle ist dafür Sorge zu tragen, dass die verwendete Trägerfolie des organischen Transistors 21, 22 eine Resistenz gegen die in dem elektrochemischen Energiespeicher 10 enthaltenen Elektrolyten oder sonstigen Stoffe aufweist.

Die Figur 2 zeigt eine schematische Darstellung eines vertikalen organischen Transistors zur Erläuterung der Erfindung.

Der organische Transistor 21 in vertikaler Anordnung umfasst beispielsweise ein Schichtsystem mit einer ersten Schicht, welche beispielsweise als eine Aluminiumfolie ausgebildet ist und welche eine Drain-Elektrode 21-1 des organischen Transistors 21 darstellt. Ferner kann eine zweite Schicht beispielsweise als eine Schicht 21-2 mit organischen elektronischen Material oder einem organischen Halbleiter, etwa Pentacene, ausgebildet sein. Eine dritte Schicht kann wieder als eine Aluminiumfolie ausgebildet sein, welche eine Source-Elektrode 21-3 des organischen Transistors 21 darstellt. Eine vierte Schicht 21-4 kann als eine Lithiumfluorid-Schicht ausgebildet sein. Eine fünfte Schicht kann wieder als eine Aluminiumfolie ausgebildet sein, welche eine Gate-Elektrode 21-5 des organischen Transistors 21 darstellt. Eine sechste Schicht kann in Form eines Glas-Trägersubstrates oder einer Trägerfolie 21-6 ausgebildet sein.

Die Stromdurchführung durch das Substrat bzw. die Trägerfolie kann durch definierte Strompfade, beispielsweise Kohlenstoffasern sichergestellt sein. Ferner kann die Trägerfolie selbst leitfähig sein, etwa Aluminiumfolie, wie in Figur 2 dargestellt.

Beispielsweise kann der organische Transistor 21, 22 der Transistoreinrichtung 20 durch einen Druckvorgang eines Tintenstrahlfoliendruckers auf die Trägerfolie aufgebracht werden.

Der im Vergleich zu kristallinen Feldeffekttransistoren erhöhte Durchlasswiderstand eines OFET kann durch die Ausbildung einer vergrößerten Flächenausdehnung des OFET kompensiert werden, welche im Wesentlichen bis auf die Fläche der verwendeten Trägerfolie anwachsen kann. Im Wesentlichen kann dies beispielsweise ein Erreichen von 95% der Fläche der verwendeten Trägerfolie bedeuten.

Der Transistor 21, 22 der Transistoreinrichtung 20 kann, wenn er sich auf einer separaten Trägerfolie befindet, beispielsweise durch Pressen oder andere bei der Zellherstellung verwendete Verfahren mit einer der Zellelektroden kontaktiert werden. Alternativ wird er direkt z. B. auf die Rückseite einer zur Kontaktierung einer Elektrode verwendeten Folie aufgebracht.

Beispielsweise kann der organische Transistor 21, 22 der Transistoreinrichtung 20 durch einen Druckvorgang eines Tintenstrahlfoliendruckers auf die Trägerfolie aufgebracht werden. Die Folientransistoreinrichtung 20 kann auf der Rückseite eines als eine Trägerfolie ausgebildeten Stromableiters 16, 17 einer Elektrode des elektrischen Energiespeichers 10 aufgebracht werden.

Die Elektrode des elektrischen Energiespeichers 10 umfasst beispielsweise einen Stromableiter, Aktivmaterialien und weitere Zusatzstoffen.

Durch die Verwendung flexibler Materialien bei der Herstellung von OFETs können diese bei der Zellfertigung einfach verarbeitet werden, beispielsweise durch einen Wickelautomaten für Elektroden, und bieten gegenüber festen Materialien wie Glas oder Keramik auch eine gewisse Beweglichkeit bei Mikrobewegungen innerhalb der Zelle, die beispielsweise durch thermische Ausdehnungsvorgänge oder durch sich ändernde Druck- oder Spannungsverhältnisse während der Ladung oder der Entladung des elektrochemischen Energiespeichers 10 entstehen.

Die Figur 3 zeigt einen Querschnitt des in der Figur 2 bereits beschriebenen vertikalen organischen Transistors 21.

Die weiteren Bezugszeichen der Figur 3 wurden bereits zuvor in der Figurenbeschreibung der Figur 2 beschrieben und werden vorliegend daher nicht weiter erläutert.

Die Figur 4 zeigt eine schematische Darstellung einer Schaltvorrichtung für einen elektrochemischen Energiespeicher gemäß einer weiteren Ausführungsform der Erfindung.

Die Schaltvorrichtung 15 für den elektrochemischen Energiespeicher 10 umfasst einen vertikalen organischen Transistor der Folientransistoreinrichtung 20. Die Schaltvorrichtung 15 ist mit dem elektrochemischen Energiespeicher 10 und einer externen Spannungsquelle 30 gekoppelt. Damit ist die Schaltvorrichtung 15 durch eine von der externen Spannungsquelle 30 erzeugte Steuerspannung, welche über eine Gate-Elektrode angelegt wird, steuerbar.

Bei der vertikalen Anordnung oder der vertikalen Struktur fließt der Strom durch den eingeschalteten Transistor 21, 22, also von Drain zu Source. Gate ist der Steueranschluss, über den der Transistor 21, 22 geschaltet wird. Ist nun die Trägerfolie, auf die die Transistorstruktur aufgebracht ist, leitfähig, so kann der Strom direkt in die Folie fließen.

Diese Struktur lässt sich somit großflächig auf Folien herstellen. Die Kontaktierung von Drain kann durch eine weitere Leitfolie hergestellt werden, die oben auf der Transistorstruktur liegt und welche beispielsweise durch Pressen oder andere Verfahren kontaktiert wird.

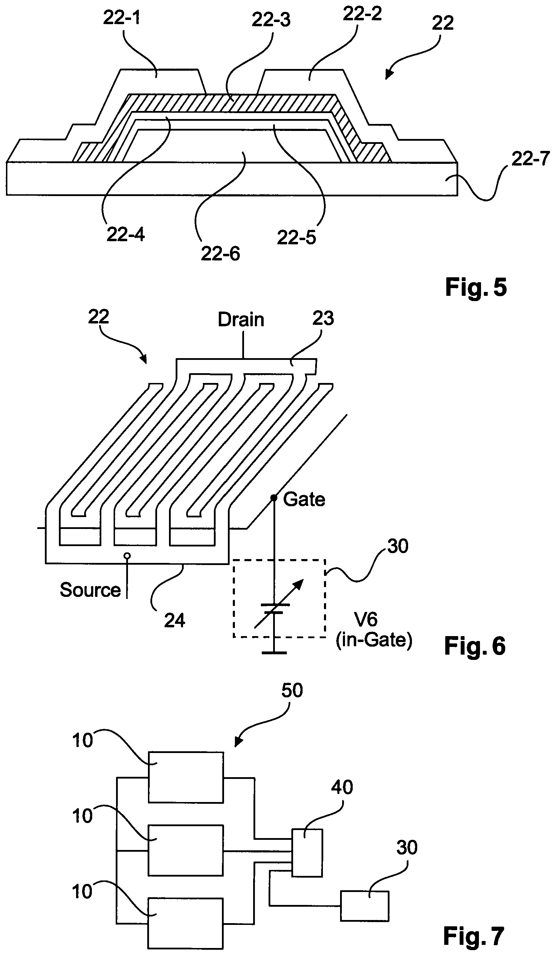

Die Figur 5 zeigt eine schematische Darstellung eines horizontalen organischen Transistors zur Erläuterung der Erfindung.

Der organische Transistor 21, 22 kann in einer vertikalen Anordnung oder in Form einer horizontalen Anordnung ausgebildet sein. Bei einer horizontalen Anordnung erfolgt die Stromleitung parallel zur Trägerfolie. Hier ist eine leitfähige Struktur erforderlich, um den OFET zu kontaktieren. Eine mögliche horizontale Anordnung ist in der Figur 5 dargestellt.

Der organische Transistor 22 in horizontaler Anordnung umfasst beispielsweise ein Schichtsystem mit einer ersten Schicht, welche beispielsweise als eine Aluminiumfolie ausgebildet ist und welche eine Drain-Elektrode 22-1 des organischen Transistors 22 darstellt. Eine zweite Schicht kann wieder als eine Aluminiumfolie ausgebildet sein, welche eine Source-Elektrode 22-2 des organischen Transistors 22 darstellt. Ferner kann eine dritte Schicht beispielsweise als eine Schicht 22-3 mit organischen elektronischen Material oder einem organischen Halbleiter, etwa Pentacene, ausgebildet sein. Eine vierte Schicht 22-4 kann als eine dielektrische Schicht ausgebildet sein, etwa eine selbstorganisierende Monoschicht (engl, selfassembled monolayer), SAM oder Aluminiumoxid.

Eine fünfte Schicht 22-5 kann wieder als eine Aluminiumfolie ausgebildet sein, welche eine Gate-Elektrode 22-6 des organischen Transistors 22 darstellt, dabei kann eine weitere metallische Zwischenschicht 22-6 als sechste Schicht ausgebildet sein.

Der organische Transistor 22 kann ferner auf einer Trägerfolienschicht 22-7 angeordnet sein, wobei diese nicht durchgehend leitfähig ausgebildet sein kann.

Die Figur 6 zeigt eine schematische Darstellung einer Schaltvorrichtung für einen elektrochemischen Energiespeicher gemäß einer weiteren Ausführungsform der Erfindung.

Der organische Feldeffekt-Transistor 22 kann Quellen- und Senkenbereiche aufweisen, welche jeweils eine Mehrzahl von ineinandergreifenden Kontaktfingern aufweisen. Ein Drain-Kontaktfinger 23 und ein Source-Kontaktfinger 24 liegen ineinandergreifend auf der gleichen Trägerfolie. Der OFET wird zwischen den Fingern angeordnet. Die Trägerfolie stellt zugleich die Trennung zu Gate dar. Die Schaltvorrichtung 15 ist mit einer externen Spannungsquelle 30 gekoppelt.

Es sind auch andere Anordnungen und Ausbildungen der Kontaktierung möglich, abweichend von den dargestellten ineinandergreifenden Fingern, wenn diese Anordnungen und Ausbildungen schaltungstechnisch das gleiche Ergebnis erzielen.

So kann beispielsweise auch eine beliebige Kammstruktur anstelle der dargestellten Fingerstruktur verwendet werden.

Die Schaltvorrichtung kann auch als Schutzschalter verwendet werden, welcher im Fehlerfall den Stromfluss innerhalb der Zelle unterbindet. Da dies innerhalb der von außen zugänglichen Zellverbinder geschieht, kann eine defekte Zelle auch mittels eines parallelen Zweiges überbrückt werden.

Sind mehrere so ausgestattete Zellen in Reihe zu einem Strang geschaltet und ist jede dieser Zellen individuell ansteuerbar, so kann als weiterer Nutzen in Verbindung mit dem komplementär schaltbaren Überbrückungspfad der jeweiligen Zelle mit der Schrittweite einer Zellspannung die Gesamtspannung des Stranges eingestellt werden.

Die Figur 7 zeigt eine schematische Darstellung eines Energiespeichersystems gemäß einer weiteren Ausführungsform der Erfindung.

Das Energiespeichersystem 50 umfasst beispielsweise mindestens zwei elektrochemische Energiespeicher 10, und mindestens eine Spannungsquelle 30 und eine Steuereinrichtung 40, welche dazu ausgelegt ist, eine Ausgangsspannung des Energiespeichersystems mit Hilfe von den Schaltvorrichtungen 15 der elektrischen Energiespeicher 10 einzustellen.

Die mindestens zwei elektrochemischen Energiespeicher 10 können parallel oder seriell oder in einer sonstigen beliebigen Weise zu einem Strang verschaltet werden.

Bei entsprechender Ansteuerung kann eine abgestufte Halbwelle durch das gesteuerte Anschließen des Stranges dargestellt werden; die Batterie kann so als eine steuerbare Spannungsquelle verwendet werden. Bei ausreichender Zellenzahl ist somit auch eine sinusnahe Modulation der Ausgangsspannung möglich.

Die Ansteuerung des in der Zelle verbauten Transistors und gegebenenfalls eines zweiten, externen oder internen Bypass-Transistors, falls vorgesehen, erfolgt vorteilhafterweise über das für Lithium-Zellen erforderliche Batteriemanagement-System, da dieses bereits auf dem Potential der jeweiligen Zelle liegt und auch entsprechende Funktionalitäten vorhanden sind.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Ergänzend sei darauf hingewiesen, dass "umfassend" und "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Schaltvorrichtung (15) für einen elektrochemischen Energiespeicher (10), mit: einer Folientransistoreinrichtung (20), welche mindestens einen organischen Transistor (21, 22) aufweist und welche innerhalb eines Schichtsystems mindestens einer Elektrode des elektrochemischen Energiespeichers (10) flächig angebracht ist und welche von einer externen Spannungsquelle (30) steuerbar ist und als ein steuerbarer elektrischer Widerstand in Reihe zu einem Innenwiderstand des elektrochemischen Energiespeichers (10) ausgebildet ist, wobei die Folientransistoreinrichtung (20) dazu ausgebildet ist, in einer Zelle des elektrochemischen Energiespeichers (10) angeordnet zu werden.

2. Schaltvorrichtung nach Anspruch 1, wobei die Schaltvorrichtung (15) ferner eine Regelungseinrichtung aufweist, welche dazu ausgebildet ist, den aktuell vorherrschenden Innenwiderstand des elektrochemischen Energiespeichers (10) zu erfassen und basierend auf dem erfassten Innenwiderstand einen Gesamtwiderstand des Innenwiderstands und des in Reihe zugeschalteten steuerbaren elektrischen Widerstands einzustellen.

3. Schaltvorrichtung nach einem der Ansprüche 1 bis 2, wobei die Folientransistoreinrichtung (20) räumlich getrennt von einem Aktivmaterial (11, 13) der Elektrode ist.

4. Schaltvorrichtung nach einem der Ansprüche 1 bis 3, wobei der organische Transistor (21, 22) zwischen mindestens zwei Metallfolien angeordnet ist.

5. Schaltvorrichtung nach einem der Ansprüche 1 bis 4, wobei der mindestens eine organische Transistor (21, 22) der Folientransistoreinrichtung (20) als ein organischer Feldeffekt-Transistor ausgebildet ist.

6. Schaltvorrichtung nach Anspruch 5, wobei der organische Feldeffekt-Transistor in vertikaler Anordnung ausgebildet ist.

7. Schaltvorrichtung nach Anspruch 5, wobei der organische Feldeffekt-Transistor in horizontaler Anordnung ausgebildet ist.

8. Schaltvorrichtung nach einem der Ansprüche 5 bis 7, wobei der organische Feldeffekt-Transistor Quellen- und Senkenbereiche aufweist, welche jeweils eine Mehrzahl von ineinandergreifenden Kontaktfingern oder eine elektrisch adäquate Verschaltung aufweisen.

9. Schaltvorrichtung nach einem der Ansprüche 1 bis 8, wobei die Folientransistoreinrichtung (20) dazu ausgebildet ist, auf der mindestens einen Elektrode des elektrochemischen Energiespeichers (10) mit Hilfe von einem Druckverfahren angebracht zu werden.

10. Schaltvorrichtung nach einem der Ansprüche 1 bis 9, wobei eine Flächenausdehnung der Folientransistoreinrichtung (20) im Wesentlichen einer Flächenausdehnung der Elektrode entspricht.

11. Schaltvorrichtung nach einem der Ansprüche 1 bis 10, wobei die Folientransistoreinrichtung (20) biegsam ausgebildet ist.

12. Elektrochemischer Energiespeicher mit einer Schaltvorrichtung (15) nach einem der Ansprüche 1 bis 10.

13. Energiespeichersystem mit mindestens zwei elektrochemischen Energiespeichern (10) nach Anspruch 12 und mindestens einer Spannungsquelle (30).

14. Energiespeichersystem nach Anspruch 13, welches eine Steuereinrichtung (40) aufweist, welche dazu ausgelegt ist, eine Ausgangsspannung des Energiespeichersystems mit Hilfe von den Schaltvorrichtungen der elektrischen Energiespeicher einzustellen.

## Claims

1. Switching device (15) for an electrochemical energy store (10), with: a film transistor device (20), which includes at least one organic transistor (21, 22) and which is attached in planar manner to at least one electrode of the electrochemical energy store (10), and which is controllable by an external voltage source (30) and is configured as a controllable electrical resistor in series with an in internal resistance of the electrochemical energy store (10), wherein the film transistor device (20) is configured to be arranged in a cell of the electrochemical energy store (10).

2. Switching device of claim 1, wherein the switching device (15) further includes a control device which is configured to determine the currently predominant internal resistance of the electrochemical energy store (10), and on the basis of the determined internal resistance to set a total resistance of the internal resistance and the controllable electrical resistance that is connected in series.

3. Switching device of any of claims 1 to 2, wherein the film transistor device (20) is spatially separated from an active material (11, 13) of the electrode.

4. Switching device of any of claims 1 to 3, wherein the organic transistor (21, 22) is arranged between at least two metal films.

5. Switching device of any of claims 1 to 4, wherein the at least one organic transistor (21, 22) of the film transistor device (20) is configured as an organic field effect transistor.

6. Switching device of claim 5, wherein the organic field effect transistor is configured in a vertical arrangement.

7. Switching device of claim 5, wherein the organic field effect transistor is configured in a horizontal arrangement.

8. Switching device of any of claims 5 to 7, wherein the organic field effect transistor has source and drain areas, each of which is furnished with meshing contact fingers or an electrically suitable circuitry.

9. Switching device of any of claims 1 to 8, wherein the film transistor device (20) is configured to be attached to the at least one electrode of the electrochemical energy store (10) by means of a printing process.

10. Switching device of any of claims 1 to 9, wherein an areal extent of the film transistor device (20) substantially corresponds to an areal extent of the electrode.

11. Switching device of any of claims 1 to 10, wherein the film transistor device (20) has a flexible structure.

12. Electrochemical energy store with a switching device (15) of any of claims 1 to 10.

13. Energy storage system with at least two electrochemical energy stores (10) of claim 12 and at least one voltage source (30).

14. Energy storage system of claim 13, having a control device (40) that is configured to set an output voltage of the energy storage system using the switching devices of the electrical energy stores.

## Revendications

1. Dispositif de commutation (15) pour un accumulateur d'énergie électrochimique (10), comprenant: un moyen de transistor de film (20) ayant au moins un transistor organique (21, 22) et que est monté à plat dans un système de couches sur au moins une électrode de l'accumulateur d'énergie électrochimique et qui peut être commandé à partir d'une source d'alimentation externe (30) et qui est réalisé sous la forme d'une résistance électrique contrôlable en série avec une résistance interne de l'accumulateur d'énergie électrochimique (10), ledit transistor à film (20) est adapté pour être arrangé dans une cellule de l'accumulateur d'énergie électrochimique (10).

2. Dispositif de commutation selon la revendication 1, dans lequel le dispositif de commutation (15) comprend en outre un moyen de commande qui est adapté pour détecter la résistance interne qui prévaut actuellement de l'accumulateur d'énergie électrochimique (10) et basé sur la résistance interne détectée pour définir une résistance totale de la résistance interne et la résistance électrique contrôlable connectée en série.

3. Dispositif de commutation selon l'une quelconque des revendications 1 à 2, dans lequel le moyen de transistor à film (20) est spatialement séparées à partir d'un matériau actif (11, 13) de l'électrode.

4. Dispositif de commutation selon l'une quelconque des revendications 1 à 3, dans lequel le transistor organique (21, 22) est disposé entre au moins deux feuilles métalliques.

5. Dispositif de commutation selon l'une quelconque des revendications 1 à 4, dans lequel le au moins un transistor organique (21, 22) de moyen de transistor à film (20) est réalisé sous la forme d'un transistor à effet de champ organique.

6. Dispositif de commutation selon la revendication 5, dans lequel le transistor à effet de champ organique est formé selon un agencement vertical.

7. Dispositif de commutation selon la revendication 5, dans lequel le transistor à effet de champ organique est formé selon un arrangement horizontal.

8. Dispositif de commutation selon l'une quelconque des revendications 5 à 7, dans lequel le transistor à effet de champ organique ayant des régions de source et de drain, chacune ayant une pluralité de doigts de contact d'accouplement ou une interconnexion électrique adéquate.

9. Dispositif de commutation selon l'une quelconque des revendications 1 à 8, dans lequel ledit transistor à film (20) est adapté pour être monté sur l'au moins une électrode de l'accumulateur d'énergie électrochimique (10) au moyen d'un procédé d'impression.

10. Dispositif de commutation selon l'une quelconque des revendications 1 à 9, dans lequel une surface du moyen de transistor à film (20) sensiblement correspond à une surface des électrodes.

11. Dispositif de commutation selon l'une quelconque des revendications 1 à 10, dans lequel les moyens de transistor à film (20) est flexible.

12. Accumulateur d'énergie électrochimique avec un dispositif de commutation (15) selon l'une des revendications 1 à 10.

13. Système de stockage d'énergie comportant au moins deux accumulateurs d'énergie électrochimique (10) selon la revendication 12 et au moins une source de tension (30).

14. Système d'accumulateur d'énergie selon la revendication 13, comprenant un dispositif de commande (40) qui est adapté pour ajuster une tension de sortie du système d'accumulateur d'énergie à l'aide des dispositifs de commutation de l'accumulateur d'énergie électrique.
